# EUROPEAN PATENT APPLICATION

(11) **EP 1 919 028 A1**
(43) Date of publication of application: **07.05.2008**
(21) Application number: 06796687.9
(22) Date of filing: 23.08.2006
(51) Int. Cl.: H01Q 1/24, H01Q 1/08, H01Q 9/16, H04M 1/02

(54) **PORTABLE WIRELESS DEVICE**

(30) Priority: 24.08.2005 JP 2005242622; 23.06.2006 JP 2006174389
(71) Applicant: NEC Corporation, Minato-ku Tokyo 108-8001 (JP)
(72) Inventor: KOJIMA, Takuya, Saitama 3670297 (JP)
(74) Representative: Glawe, Delfs, Moll
(86) International application number: PCT/JP2006/316524
(87) International publication number: WO 2007/023868

(57) **Abstract**

A portable wireless device such as a foldable portable telephone is provided.

A feeder line 7 is arranged between an upper printed board 4 and a lower printed board 5 to feed power, the upper printed board 4 and the lower printed board 5 constitute radiating elements, respectively, to allow a portable wireless device main body to operate as a dipole antenna, and an upper-to-lower circuit connecting unit 6 connecting the upper printed board 4 to the lower printed board 5 is configured to include a feeder line 7 and signal lines 10 connecting a circuit unit of the upper printed board 4 to a circuit unit of the lower printed board 5 to cause a receiver, a display 8, a microphone, an external interface and the like to operate. It is thereby possible to prevent the feeder line 7 and the signal lines 10 from rubbing against each other to damage the signal lines 10 when the foldable portable wireless device is open or closed, and to realize downsizing of the foldable portable wireless device.

## Description

### TECHNICAL FIELD

The present invention pertains to a portable wireless device and particularly to a portable wireless device such as a foldable wireless telephone.

### BACKGROUND ART

A foldable wireless device, which is a type of a structure of a portable telephone, is structured so that an upper case and a lower case are rotatably connected to each other by a hinge unit to provide a freely open or closed mechanism. This foldable portable telephone can be provided with a large-sized display screen in the upper case and has advantages of user-friendliness when a user uses the telephone left open and of a compact form in a closed state.

Furthermore, recent portable telephones are increasingly becoming smaller in size and thinner. Accordingly, space for packaging an antenna is narrower because of an improvement in camera performance and implementation of a non-contact IC card.

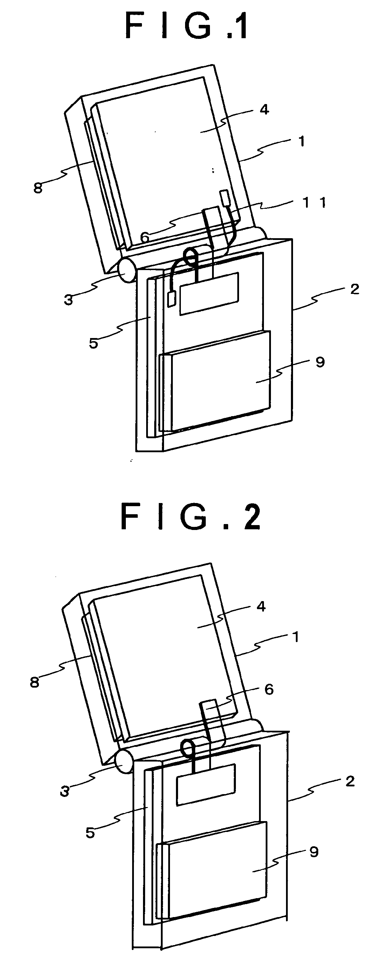

A configuration of a conventional foldable portable wireless device using circuit boards as radiating elements of a dipole antenna will be described with reference to Fig. 1. As shown in Fig. 1, the conventional foldable portable wireless device is configured to include an upper case 1, a lower case 2, a hinge unit 3, an upper-lower circuit connecting unit 6, and a cable 11 serving as a feeder line. An upper printed board 4, a display 8 and the like are accommodated in the upper case 1, and a lower printed board 5, a battery 9 and the like are accommodated in the lower case 2. According to the configuration shown in Fig. 1, power is supplied after the cable 11 is arranged between the upper printed board 4 and the lower printed board 5, thereby allowing the upper printed board 4 and the lower printed board 5 to serve as radiating elements to constitute a dipole antenna. The foldable portable wireless device is thereby downsized.

Patent Document 1 proposes the following portable terminal. In the portable terminal including a first case and a second case and structured to mount a first circuit unit and a second circuit unit in the respective cases, the first case or the first circuit unit and the second circuit unit or the second case are allowed to function as a pair of radiating (antenna) elements of a dipole antenna, respectively, whereby the first and second cases are insulated from each other in terms of high frequency. The first and second circuit units (including the circuit boards) are connected to each other by direct current (DC). One end of the feeder line is connected to a feeder circuit of the first circuit unit and the other end thereof is connected to the first case or the first circuit unit, whereby an antenna can be constituted only by providing the feeder line. Therefore, there is no need to use special built-in antenna elements, and it is possible to realize a smaller and cost-reduced portable terminal.

Patent Document 2 proposes the following antenna device. A first dielectric case in which a first conductor plate is arranged and a second dielectric case in which a second conductor plate is arranged are configured to be foldable or slidable. A high frequency power supply applying a high frequency voltage to the first and second conductor plates is provided in the first or second dielectric case. It is thereby possible to constitute a dipole antenna out of the first conductor plate, the second conductor plate, and the high frequency power supply, and to use the first and second conductor plates that serve as circuit boards as radiating elements. Therefore, there is no need to additionally provide radiating elements as seen in a conventional antenna device, and it is possible to realize a smaller wireless device.

Patent Document 3 proposes the following portable wireless device. The portable wireless device is a foldable portable wireless device having a freely openable and closable mechanism in which an upper case and a lower case are connected to each other by a hinge unit. An extensible antenna element that can be pulled out from within one of the upper case and the lower case is provided in the upper or lower case. In the case including a handle for pulling out the extensible antenna element from within one of the cases on its tip end and including therein the extensible antenna element, a concave portion is provided so that the handle is flush with an outer wall of the case while the extensible antenna element is stored in the case. Due to this, even if a user makes a telephone call while holding the telephone by his or her hand, higher antenna gain than that in a state in which the extensible antenna element is stored in the case can be obtained by pulling out the extensible antenna element from within the case.
Patent Document 1: Japanese Patent Application Laid-Open No. 2004-172919
Patent Document 2: Japanese Patent Application Laid-Open No. 2004-208219
Patent Document 3: Japanese Patent Application Laid-Open No. 2004-242005

### DISCLOSURE OF THE INVENTION

### PROBLEMS TO BE SOLVED BY THE INVENTION

However, the above-stated inventions have the following problems.

In the portable terminal described in the Patent Document 1, circuit units 10 and 11 included in upper and lower cases 1 and 2 are connected to each other by an upper-to-lower circuit connecting unit 18 in terms of DC, and the upper case 1 and the lower case 2 (lower case circuit unit 11) are connected to each other by a feeder line 13 in terms of high frequency. Due to this, whenever the foldable portable wireless device is opened or closed, the upper-to-lower circuit connecting unit 18 and the feeder line 13 rub against each other. The upper-to-lower circuit connecting unit 18 is broken in the worst case, with the result that the portable wireless device becomes inoperable. Further, a connector connecting the feeder line 13 to a board needs to be incorporated in the portable wireless device described in the Patent Document 1. Therefore, the portable wireless device needs space for incorporating the connector.

In the antenna device described in the Patent Document 2, a first dielectric case 6 in which a first conductor plate 1 is arranged and a second dielectric case 7 in which a second conductor plate 2 is arranged are configured to be foldable. A high frequency power supply 5 applying a high frequency voltage to the first conductor plate 1 and the second conductor plate 2 is disposed in either the first dielectric case 6 or the second dielectric case 7, whereby the first conductor plate 1, the second conductor plate 2, and the high frequency power supply 5 constitute the dipole antenna. However, it is necessary to connect the first conductor plate 1 to the second conductor plate 2 by two lines of a conductor line bundle 3 and a conductor line 9.

The portable wireless device described in the Patent Document 3 includes a first antenna element 1 arranged in an upper case 4, a second antenna element 2 arranged in a lower case 5 and constituting, together with the first antenna element 11, a dipole antenna, and an extensible antenna element 3 provided in the upper case 4 to be extensible upward out of the upper case 4. Further, the portable wireless device includes an electric connecting unit 8 electrically connecting the extensible antenna element 3 to the first antenna element 1 on the upper case 4 side when the extensible antenna element 3 extends. However, it is necessary to provide a feeder line 12 connecting a matching circuit 13 to the antenna element 1 separately from the electric connecting unit 8.

It is, therefore, an object of the present invention to propose a portable wireless device configured so that a feeder line is arranged between an upper printed board and a lower printed board to feed power, the upper printed board and the lower printed board constitute radiating elements, respectively, a portable wireless device main body is allowed to operate as a dipole antenna, and an upper-to-lower circuit connecting unit connecting the upper printed board to the lower printed board includes a feeder line and a signal line connecting a circuit unit of the upper printed board to a circuit unit of the lower printed board to cause a receiver, a display, a microphone, an external interface and the like to operate.

According to an invention set forth in claim 1, there is provided a portable wireless device including a first case, a second case, and circuit units stored in the first case and the second case, respectively, and allowing the first case and the second case to operate as a pair of radiating elements of a dipole antenna, including: a first-to-second circuit connecting unit connecting the circuit units stored in the first case and the second case to each other; a feeder unit electrically connected to the respective circuit units; and a feeder line included in the first-to-second circuit connecting unit, and electrically connecting each of the circuit units to the feeder unit.

According to an invention set forth in claim 2, there is provided the portable wireless device according to claim 1, wherein the first-to-second circuit connecting unit includes a signal line transferring a signal transmitted or received by each of the circuit units.

According to an invention set forth in claim 3, there is provided the portable wireless device according to claim 2, wherein the first-to-second circuit connecting unit includes two layers of the signal lines.

According to an invention set forth in claim 4, there is provided the portable wireless device according to claim 2 or 3, wherein the first-to-second circuit connecting unit includes a tri-plate line structure in which the signal line is vertically covered with a ground.

According to an invention set forth in claim 5, there is provided the portable wireless device according to any one of claims 1 to 4, including a hinge mechanism rotatably connecting the first case to the second case.

According to an invention set forth in claim 6, there is provided the portable wireless device according to any one of claims 1 to 5, wherein the first-to-second circuit connecting unit is made of a flexible board.

According to an invention set forth in claim 7, there is provided the portable wireless device according to any one of claims 1 to 6, wherein the feeder line is a strip line.

According to an invention set forth in claim 8, there is provided the portable wireless device according to any one of claims 2 to 7, wherein a distance between the signal line and the feeder line is larger than a distance between the signal lines.

According to an invention set forth in claim 9, there is provided the portable wireless device according to any one of claims 1 to 8, wherein a display is incorporated in the first case.

According to an invention set forth in claim 10, there is provided the portable wireless device according to any one of claims 1 to 9, wherein the feeder unit is a high frequency power supply supplying a high frequency voltage to the first case and the second case.

According to an invention set forth in claim 11, there is provided the portable wireless device according to any one of claims 1 to 10, wherein a battery is incorporated in the second case.

According to an invention set forth in claim 12, there is provided the portable wireless device according to any one of claims 1 to 11, wherein the circuit unit packaged in the first case and the feeder line are capacitively-coupled to each other.

### ADVANTAGE OF THE INVENTION

According to the present invention, the feeder line is arranged between the upper printed board and the lower printed board to feed power, the upper printed board and the lower printed board constitute radiating elements, respectively, a portable wireless device main body is allowed to operate as a dipole antenna, and an upper-to-lower circuit connecting unit connecting the upper printed board to the lower printed board is configured to include the feeder line and the signal lines connecting the circuit unit of the upper printed board to the circuit unit of the lower printed board to cause a receiver, a display, a microphone, an external interface and the like to operate. It is thereby possible to prevent the feeder line and the signal lines from rubbing against each other to damage the signal line when the foldable portable wireless device is opened or closed, and to realize downsizing of the foldable portable wireless device.

### BEST MODE FOR CARRYING OUT THE INVENTION

A configuration and an operation of a foldable portable wireless device according to embodiments of the present invention will be described.

First, the configuration of the foldable portable wireless device according to the embodiment will be described with reference to Fig. 2. The foldable portable wireless device according to an embodiment includes an upper case 1 to which a display 8 is attached and which serves as a first case, a lower case 2 to which a key operating unit including a plurality of data input buttons or keys are attached and which serves as a second case, and a hinge unit 3 rotatably connecting the upper case 1 and the lower case 2 to each other.

An upper case front portion located on a side on which the display 8 is attached and an upper case rear portion located on an opposite side to the display 8 are attached together and form the upper case 1.

A receiver, an upper printed board 4 serving as a first board, and the display 8 are packaged in an interior of a container formed by the upper case front portion and the upper case rear portion.

Similarly to the upper case 1, A lower case front portion located on a side on which the key operating unit is attached, and a lower case rear portion located on an opposite side to the key operating unit are attached together and form the lower case 2.

A microphone, an external interface, a lower printed board 5 serving as a second board, and a battery 9 are packaged in an interior of a container formed by the lower case front portion and the lower case rear portion.

The upper printed board 4 is connected to the lower printed board 5 via an upper-to-lower circuit connecting unit 6 constituted by a flexible board.

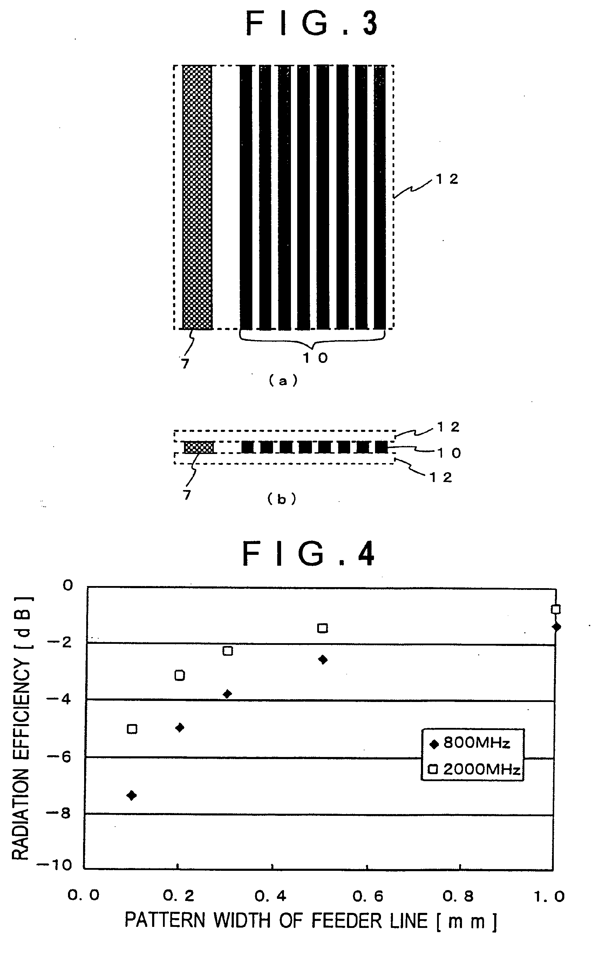

Next, a configuration of the upper-to-lower circuit connecting unit 6 will be described with reference to Fig. 3. Fig. 3(a) is a top view of the upper-to-lower circuit connecting unit 6 and Fig. 3(b) is a cross-sectional view of the upper-to-lower circuit connecting unit 6.

A feeder line 7 is arranged in the upper-to-lower circuit connecting unit 6, the upper printed board 4 and the lower printed board 5 constitute radiating elements, thus being allowed to operate as a dipole antenna. The feeder line 7 is connected to a wireless circuit output on the lower printed board 5 on the lower printed board 5 side, and to a ground of the upper printed board 4 on the upper printed board 4 side.

Further, signal lines 10 that are wiring lines connecting a circuit unit of the upper printed board 4 to that of the lower printed board 5, and causing the receiver, the display 8, the microphone, the external interface and the like to operate are arranged in the upper-to-lower circuit connecting unit 6.

Antenna operation will be described. The antenna according to the embodiment feeds power by arranging the feeder line 7 between the upper printed board 4 and the lower printed board 5. The upper printed board 4 and the lower printed board 5 constitute the respective radiating elements, and a portable wireless device main body operates as the dipole antenna. Due to this, the upper-to-lower circuit connecting unit 6 satisfies the following conditions so as to ensure antenna characteristics of the main body of the portable wireless device as the dipole antenna.

Fig. 4 is a graph showing the relationship between a width of a pattern (hereinafter, "pattern width") of the feeder line 7 and radiation efficiency. The graph shows an example in which a length of each of the upper and lower boards is set to 80 millimeters (mm) in the configuration shown in Fig. 4. As shown in and evident from Fig. 4, if the pattern width is smaller, a deterioration in the radiation efficiency is greater. It is imagined that this is because the line comes to have inductance due to the smaller pattern width. It is, therefore, preferable to set the pattern width of the feeder line 7 as large as possible.

Furthermore, in the upper-to-lower circuit connecting unit 6, the signal lines 10 and the feeder line 7 are preferably arranged to be away from each other. If the signal lines 10 and the feeder line 7 are arranged to be close to each other, then inter-line coupling is greater, and in terms of high frequency, it looks as if the feeder line 7 has a capacity. Due to this, a radiation resistance of the antenna is reduced, resulting in deterioration of the antenna characteristics.

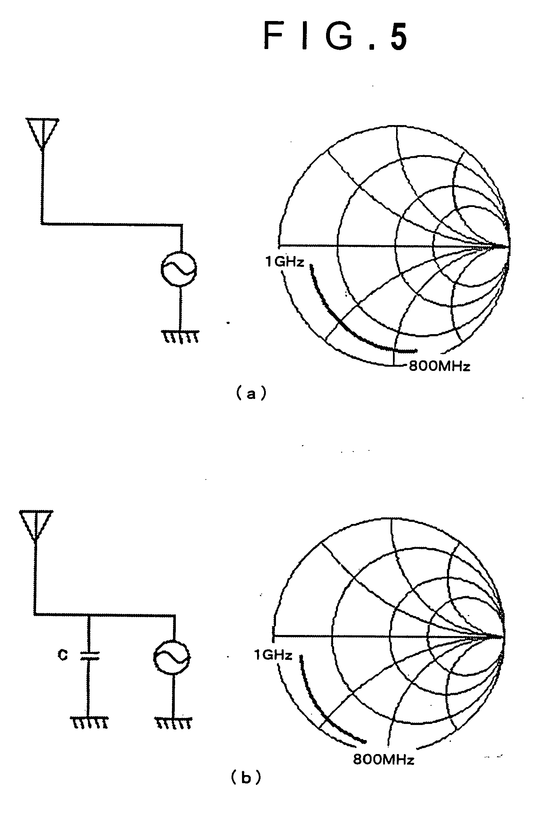

Fig. 5 shows an equivalent circuit and a Smith chart representing this state. On the Smith chart, impedances from 800 MHz to 1 GHz are indicated. Fig. 5(a) shows a state in which the distance between the signal lines 10 and the feeder line 7 is set wider. If the distance is set smaller, the resistance lowers on the Smith chart as if a capacity is added on the equivalent circuit as shown in Fig. 5(b). If the resistance is reduced, the antenna characteristics are deteriorated. It is, therefore, important to set the distance between the signal lines 10 and the feeder line 7 larger than that between the signal lines. In the embodiment, the upper printed board 4 is directly connected to the feeder line 7. However, even if the upper printed board 4 is capacitively-coupled to the feeder line 7, the dipole antenna can be similarly constituted using the printed boards.

In the foldable portable wireless device according to the embodiment, the feeder line 7 is arranged between the upper printed board 4 and the lower printed board 5 to feed power, the upper printed board 4 and the lower printed board 5 constitute radiating elements, respectively, to allow the portable wireless device main body to operate as the dipole antenna, and the upper-to-lower circuit connecting unit 6 connecting the upper printed board 4 to the lower printed board 5 is configured to include the feeder line 7 and the signal lines 10 connecting the circuit unit of the upper printed board 4 to the circuit unit of the lower printed board 5 to cause the receiver, the display 8, the microphone, the external interface and the like to operate. It is thereby possible to prevent the feeder line 7 and the signal lines 10 from rubbing against each other to damage the signal lines 10 when the foldable portable wireless device is opened or closed, and to realize downsizing of the foldable portable wireless device.

Moreover, in the foldable portable wireless device according to the embodiment, the distance between the feeder line 7 and the signal lines 10 included in the upper-to-lower circuit connecting unit 6 is set larger than that between the signal lines 10. It is thereby possible to prevent deterioration in antenna characteristics caused by a reduction in the radiation resistance of the antenna.

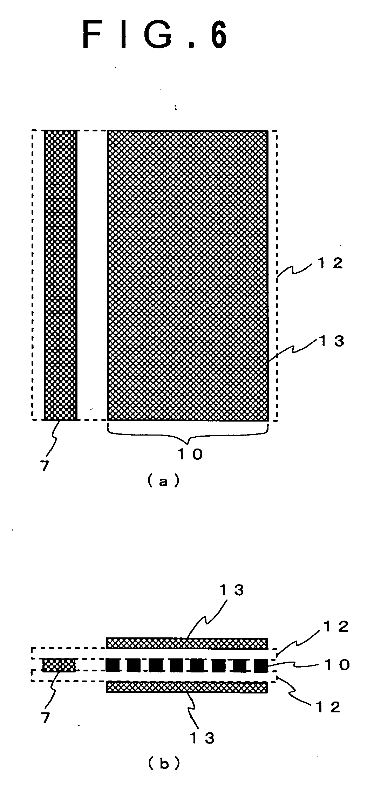

A configuration of a foldable portable wireless device according to a second embodiment of the present invention will be described with reference to Fig. 6.

Fig. 6 shows a configuration of an upper-to-lower circuit connecting unit 6 of the foldable portable wireless device according to the second embodiment of the present invention. Other constituent elements of the foldable portable wireless device according to the second embodiment are similar to those of the foldable portable wireless device according to the first embodiment. Fig. 6(a) is a top view of the upper-to-lower circuit connecting unit 6 and Fig. 6(b) is a cross-sectional view of the upper-to-lower circuit connecting unit 6.

As shown in Fig. 6, in the second embodiment, signal lines 10 included in the upper-to-lower circuit connecting unit 6 is put between grounds 13, and the upper-to-lower circuit connecting unit 6 is constituted by tri-plate lines to prevent degradation in sensitivity due to radiation of transmit waves on the signal lines 10 and noise at the time of activating a camera. In this case, to ensure antenna characteristics, a feeder line 7 is not covered with the grounds 13. By constituting the upper-to-lower circuit connecting unit 6 by the tri-plate lines, antenna efficiency can be improved.

In the foldable portable wireless device according to this embodiment, the feeder line 7 is arranged between the upper printed board 4 and the lower printed board 5 to feed power, the upper printed board 4 and the lower printed board 5 constitute radiating elements, respectively, to allow the portable wireless device main body to operate as the dipole antenna, and the upper-to-lower circuit connecting unit 6 connecting the upper printed board 4 to the lower printed board 5 is configured to include the feeder line 7 and the signal lines 10 connecting the circuit unit of the upper printed board 4 to the circuit unit of the lower printed board 5 to cause the receiver, the display 8, the microphone, the external interface and the like to operate. Further, the signal lines 10 are covered with the grounds 13. It is thereby possible to prevent deterioration in antenna characteristics caused by radiation of transmitting waves on the signal lines 10, noise and the like.

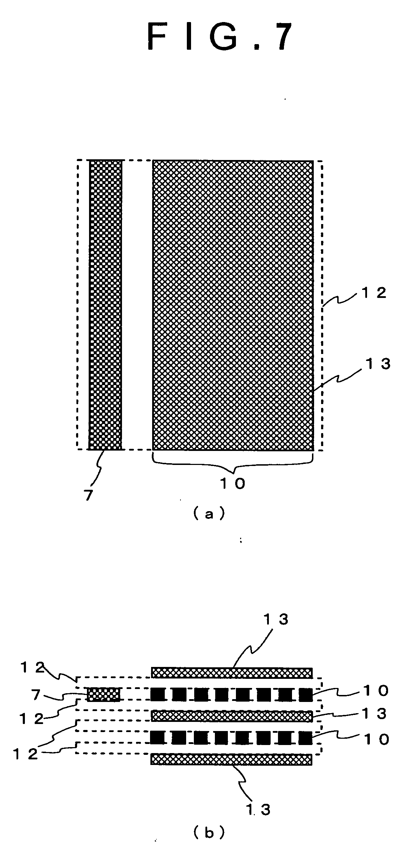

A configuration of a foldable portable wireless device according to a third embodiment of the present invention will be described with reference to Fig. 7.

Fig. 7 shows a configuration of an upper-to-lower circuit connecting unit 6 of the foldable portable wireless device according to a third embodiment of the present invention. The other constituent elements of the foldable portable wireless device according to the third embodiment are similar to those of the foldable portable wireless device according to the first embodiment. Fig. 7(a) is a top view of the upper-to-lower circuit connecting unit 6 and Fig. 7(b) is a cross-sectional view of the upper-to-lower circuit connecting unit 6.

As shown in Fig. 7, in the third embodiment, signal lines 10 have a two-layer structure. To prevent degradation in sensitivity caused by radiation of transmitting waves on the signal lines 10, noise at the time of starting a camera and the like, the upper-to-lower circuit connecting unit 6 is constituted by tri-plate lines including two-layered signal lines 10 configured so that a ground 13 is put between the upper and lower signal lines 10 of the upper-to-lower circuit connecting unit 6, and so that the upper and lower signal lines 10 are put between grounds 13. In this case, the feeder line 7 is not covered with the grounds 13 so as to ensure antenna characteristics as similar to the second embodiment.

### BRIEF DESCRIPTION OF THE DRAWINGS

Fig. 1 is a schematic diagram of a conventional foldable portable wireless device.
Fig. 2 is a schematic diagram of a foldable portable wireless device according to embodiments of the present invention.
Fig. 3(a) is a top view of an upper-to-lower circuit connecting unit of a foldable portable wireless device according to a first embodiment.
Fig. 3(b) is a cross-sectional view of the upper-to-lower circuit connecting unit of the foldable portable wireless device according to the first embodiment.
Fig. 4 is a graph showing the relationship between a pattern width of a feeder line and radiation efficiency.
Fig. 5(a) is an equivalent circuit and a Smith chart if the distance between signal lines and the feeder line is set large. Fig. 5(b) is an equivalent circuit and a Smith chart if the distance between the signal lines and the feeder line is set small.
Fig. 6(a) is a top view of an upper-to-lower circuit connecting unit of a foldable portable wireless device according to a second embodiment.
Fig. 6(b) is a cross-sectional view of the upper-to-lower circuit connecting unit of the foldable portable wireless device according to the second embodiment.
Fig. 7(a) is a top view of an upper-to-lower circuit connecting unit of a foldable portable wireless device according to a third embodiment.
Fig. 7(b) is a cross-sectional view of the upper-to-lower circuit connecting unit of the foldable portable wireless device according to the third embodiment.

### DESCRIPTION OF REFERENCE SYMBOLS

- 1: upper case
- 2: lower case
- 3: hinge unit
- 4: upper printed board
- 5: lower printed board
- 6: upper-to-lower circuit connecting unit
- 7: feeder line
- 8: display
- 9: battery
- 10: signal line
- 11: cable
- 12: base material
- 13: ground

## Claims

1. A portable wireless device including a first case, a second case, and circuit units stored in the first case and the second case, and allowing the first case and the second case to operate as a pair of radiating elements of a dipole antenna, comprising:
a first-to-second circuit connecting unit that connects the circuit units stored in the first case and the second case to each other;
a feeder unit that is electrically connected to the respective circuit units; and
a feeder line that is included in the first-to-second circuit connecting unit, and electrically connects each of the circuit units to the feeder unit.

2. The portable wireless device according to claim 1,
wherein the first-to-second circuit connecting unit includes a signal line transferring a signal transmitted or received by each of the circuit units.

3. The portable wireless device according to claim 2,
wherein the first-to-second circuit connecting unit includes two layers of signal lines.

4. The portable wireless device according to claim 2 or 3,
wherein the first-to-second circuit connecting unit includes a tri-plate line structure in which the signal line is vertically covered with a ground.

5. The portable wireless device according to any one of claims 1 to 4, comprising a hinge mechanism rotatably connecting the first case to the second case.

6. The portable wireless device according to any one of claims 1 to 5,
wherein the first-to-second circuit connecting unit is made of a flexible board.

7. The portable wireless device according to any one of claims 1 to 6,
wherein the feeder line is a strip line.

8. The portable wireless device according to any one of claims 2 to 7,
wherein a distance between the signal lines and the feeder line is larger than a distance between the signal lines.

9. The portable wireless device according to any one of claims 1 to 8,
wherein a display is incorporated in the first case.

10. The portable wireless device according to any one of claims 1 to 9,
wherein the feeder unit is a high frequency power supply supplying a high frequency voltage to the first case and the second case.

11. The portable wireless device according to any one of claims 1 to 10,
wherein a battery is incorporated in the second case.

12. The portable wireless device according to any one of claims 1 to 11,
wherein the circuit unit packaged in the first case and the feeder line are capacitively-coupled to each other.
